# EUROPEAN PATENT APPLICATION

(11) **EP 4 265 419 A1**
(43) Date of publication of application: **25.10.2023**
(21) Application number: 21906596.8
(22) Date of filing: 14.12.2021
(51) Int. Cl.: B41C 1/00, B41N 1/00, B41N 1/12, G03F 7/00, G03F 7/033, G03F 7/26

(54) **PHOTOSENSITIVE FLEXOGRAPHIC PRINTING PLATE ORIGINAL PLATE, AND FLEXOGRAPHIC PRINTING PLATE**

(30) Priority: 15.12.2020 JP 2020207269; 31.03.2021 JP 2021059745
(71) Applicant: Toray Industries, Inc., Tokyo 103-8666 (JP)
(72) Inventor: ICHIKAWA, Michihiko, Okazaki-shi, Aichi 444-8522 (JP); ONISHI, Ryo, Okazaki-shi, Aichi 444-8522 (JP); TAKANO, Hideki, Okazaki-shi, Aichi 444-8522 (JP); IDO, Kenji, Okazaki-shi, Aichi 444-8522 (JP); SUGIURA, Sho, Okazaki-shi, Aichi 444-8522 (JP)
(74) Representative: Mewburn Ellis LLP
(86) International application number: PCT/JP2021/045944
(87) International publication number: WO 2022/131234

(57) **Abstract**

A subject of the present invention is to provide an economical photosensitive flexographic printing original plate through which an antifouling property of plate surface can be sustained in a printing process and a stable printed matter can be obtained even in long-run printing. The present invention is a flexographic printing plate including at least a substrate and a photosensitive resin layer, wherein the photosensitive resin layer contains at least (a) a hydrophilic polymer, (b) a hydrophilic monomer, (c) a photoinitiator, (d) a hydrophilic plasticizer, and (e) an ink repellent, and when the flexographic printing plate is exposed and developed to reproduce 99 or more of 175 lpi, 3% halftone dots among 100 dots, a contact angle of the photosensitive resin layer after photocuring with respect to tripropylene glycol diacrylate is 40° or more and 70° or less, and a mass change rate of the photosensitive resin layer after the photocuring after immersion in the tripropylene glycol acrylate at 50°C for 24 hours is -4.0% or more and 4.0% or less.

## Description

### TECHNICAL FIELD

The present invention relates to a photosensitive flexographic printing original plate and a flexographic printing plate.

### BACKGROUND ART

Printing techniques have recently experienced great development, and especially, flexographic printing has a wide variety of applications because it can be applied to any medium, and is also used for soft wrapping applications and electronics applications including corrugated cardboards, paper cartons and labels. In addition, as for a concern for the environment, a water-developable flexographic printing plate, which can be developed with water, has been introduced in place of the conventional treatment involving development using an organic solvent.

Letterpress printing represented by flexographic printing is performed by applying an ink to apexes of a convex relief, press-attaching the convex relief with a printed medium, thereby transferring the ink. Since the printing is performed in this way, a phenomenon may occur that ink applied to apexes of the relief, especially to apexes of halftone dots, is squeezed out to slopes of the halftone dots to enter concave portions during impressing. Since the ink squeezed out wet-spreads on a plate surface forming the halftone dots, there is a problem such that the halftone dots are linked by the ink in a region of a printed matter where dot printing should be applied as a result of which a printing defect called dot bridging is formed. In particular, a phenomenon of dot bridging tends to occur because flexographic printing ink has a lower viscosity than letterpress printing ink. In addition, there is also a secondary problem such that work time for wiping off the wet-spread ink on a printing plate results in an opportunity loss, decreasing the productivity. In order to solve these problems, various methods have been proposed.

Patent Document 1 has proposed a method for suppressing the dot bridging of ink by using a water-developable photosensitive flexographic printing original plate that includes a fluorine-containing compound having an ionic functional group.

Patent Document 2 has proposed a method for controlling surface energy of a relief formed by photocuring a photosensitive resin layer and suppressing ink entanglement with the help of a photosensitive flexographic printing original plate that is also water-developable and includes a silicone component.

### PRIOR ART DOCUMENTS

### PATENT DOCUMENTS

Patent Document 1: PCT International Publication No. 2018/88336
Patent Document 2: Japanese Patent Laid-open Publication No. 2018-120131

### SUMMARY OF THE INVENTION

### PROBLEMS TO BE SOLVED BY THE INVENTION

The disclosure of Patent Document 1 poses a problem such that although a certain effect of suppressing ink entanglement can be obtained because entry of the ink into the concave portions can be suppressed, a decrease in printing density may occur in long-run printing. The decrease in printing density requires that the printing machine be stopped at any time and adjust pressurization of printing pressure at any time.

The disclosure of Patent Document 2 poses a problem such that although a certain effect of suppressing ink entanglement can be obtained because entry of the ink into the concave portions can be suppressed, halftone dots may become thicker in long-run printing.

The present invention has been made in view of the above circumstances, and an object of the present invention is to provide an economical photosensitive flexographic printing original plate through which an antifouling property on plate surface can be sustained in a printing process and a stable printed matter can be obtained even in long-run printing.

### SOLUTIONS TO THE PROBLEMS

The present inventors have found that the decrease in printing density in the invention described in Patent Document 1 is caused by a fact that an uncured component in the printing relief is extracted into ink, making the printing relief thinner (with a lower height). In addition, it has been found that dot gain in the technique described in Patent Document 2 is caused by the expansion of a convex portion because the printing relief includes, as a main component, a rubber component that easily swells in the ink. In view of these findings, the present inventors have conceived the present invention as a result of intensive studies.

In other words, the present invention is a photosensitive flexographic printing original plate including at least a substrate and a photosensitive resin layer, wherein the photosensitive resin layer contains at least (a) a hydrophilic polymer, (b) a hydrophilic monomer, (c) a photoinitiator, (d) a hydrophilic plasticizer, and (e) an ink repellent, and when the photosensitive resin layer is exposed to reproduce 99 or more of 175 lpi, 3% halftone dots among 100 dots, a contact angle of the photosensitive resin layer after photocuring with respect to tripropylene glycol diacrylate is 40° or more and 70° or less, and a mass change rate of the photosensitive resin layer after the photocuring after immersion in the tripropylene glycol acrylate at 50°C for 24 hours is -4.0% or more and 4.0% or less.

The present invention is also a flexographic printing plate including a resin layer having at least a printing relief formed on a substrate, wherein a contact angle of a convex portion of the printing relief with respect to tripropylene glycol diacrylate is 40° or more and 70° or less, and a mass change rate of the convex portion of the printing relief after immersion in tripropylene glycol diacrylate at 50°C for 24 hours is -4.0% or more and 4.0% or less.

### EFFECTS OF THE INVENTION

According to the present invention, a plate surface stain caused by wet-spread of the ink between the halftone dots is prevented in the printing process, and it is possible to continuously provide a high-quality printed matter stable in halftone density even in the long-run printing without stopping the printing machine.

### EMBODIMENTS OF THE INVENTION

Hereinafter, the present invention will be described in detail. Note that in the present invention, "or more" means the same as or more than a numerical value indicated therein. In addition, "or less" means the same as or less than a numerical value indicated therein.

The flexographic printing plate of the present invention and the photosensitive flexographic printing original plate of the present invention have substrates. The substrate supports, for example, a resin layer on which a printing relief is formed in the flexographic printing plate of the present invention, or a photosensitive resin layer in the photosensitive flexographic printing original plate of the present invention.

The substrate is preferably excellent in dimensional stability against heat or physical stress, and in use, may be, for example, a plastic sheet such as polyester, or a metal plate such as steel, stainless steel or aluminum.

A thickness of the substrate is preferably 100 um or more and 350 um or less from the viewpoint of handleability and flexibility. When the thickness is 100 um or more, the handleability as a support is improved, and when the thickness is 350 um or less, the flexibility as the photosensitive flexographic printing original plate and the flexographic printing plate is improved.

In addition, the substrate may be subject to adhesion-promoting treatment for the purpose of improving adhesion between the substrate and the photosensitive resin layer. Although examples of a method of the adhesion-promoting treatment can include mechanical treatment such as sandblasting, physical treatment such as corona discharge, and chemical treatment by coating, it is preferable to provide an easily adhesive layer by coating from the viewpoint of adhesion.

The flexographic printing plate of the present invention has the resin layer on which at least the printing relief is formed on the substrate. In addition, the photosensitive flexographic printing original plate of the present invention includes at least the photosensitive resin layer on the substrate. Forming irregularities in the photosensitive resin layer by a predetermined method makes it possible to form the printing relief in the flexographic printing plate, that is, the resin layer has the printing relief formed thereon.

In the photosensitive flexographic printing original plate of the present invention, the photosensitive resin layer includes at least (a) a hydrophilic polymer, (b) a hydrophilic monomer, (c) a photoinitiator, (d) a hydrophilic plasticizer, and (e) an ink repellent.

(a) The hydrophilic polymer in the photosensitive resin layer of the photosensitive flexographic printing original plate of the present invention serves as a binder resin of the photosensitive flexographic printing original plate that is water-developable.

As (a) the hydrophilic polymer, in order to suppress a swelling rate to UV ink, it is preferable to use a hydrophilic polymer having an SP value (a solubility parameter) with a large difference from an SP value of the UV ink component, and it is more preferable to use a hydrophilic polymer having an SP value of 12 or more. With the use of the hydrophilic polymer having the SP value of 12 or more, the swelling rate of the UV ink can be controlled to 4.0% or less.

In addition, the (a) hydrophilic polymer preferably has at least one of a hydroxy group, an amino group, an amide group, a carboxy group, and a phosphate group as a functional group because of excellent water-developability, and more preferably has at least a hydroxy group. Although examples of (a) the hydrophilic polymer include polyvinyl alcohol, polyamide, polyvinyl pyrrolidone, polyether, water-soluble polyester, in particular, the polyvinyl alcohol is preferable from a viewpoint of solubility in water, simplicity of processing, and sharpness of the printing relief to be obtained. The polyvinyl alcohol can give variations in solubility depending on a saponification degree, but in view of difficulty in being processed as a stock aqueous solution and rigidity of the resin itself due to intramolecular hydrogen bonding in complete saponification, polyvinyl alcohol that is at least partially saponified, namely, partially saponified polyvinyl alcohol is preferable. As for the saponification degree, from the viewpoint of water-developability, the saponification degree is preferably 50 mol% or more and 99 mol% or less, more preferably 60 mol% or more and 90 mol% or less.

As for a method of measuring the saponification degree, a 3% aqueous solution of partially saponified polyvinyl alcohol to be measured is subject to complete saponification treatment with an excessive amount of 0.5 mol/L aqueous sodium hydroxide solution, then the amount of sodium hydroxide required for a complete saponification is measured by titration with 0.5 mol/L hydrochloric acid, and thereby the saponification degree can be calculated.

The content of (a) the hydrophilic polymer in the photosensitive resin layer is preferably 20% by mass or more and 80% by mass or less with respect to 100% by mass of the photosensitive resin layer. Since (a) the hydrophilic polymer is contained in an amount of 20% by mass or more, more preferably 30% by mass or more, a strength for withstanding the printing can be obtained. In addition, setting the content to 80% by mass or less, more preferably 60% by mass or less, makes it possible to obtain a hardness suitable for the flexographic printing plate after the photocuring.

(b) The hydrophilic monomer is a monomer having a hydrophilic functional group, and has a carbon-carbon unsaturated group in which a polymerization reaction is initiated by light. The hydrophilic functional group is preferably at least one of a hydroxy group, an amino group, an amide group, a carboxy group, and a phosphate group, and more preferably a hydroxy group. Although a part of the printing relief is formed through the photocuring, with the hydrophilic functional group, the water development is facilitated, and polarity is separated from the UV ink component. Therefore, swelling with respect to the UV ink and changes in physical properties can be suppressed.

Specific examples of (b) the hydrophilic monomer include 2-hydroxy-3-acryloyloxypropyl methacrylate, a reaction product of 2-acryloyloxyethylsuccinic acid and glycidyl methacrylate, a reaction product of 2-acryloyloxyethyl-2-hydroxyethyl-phthalic acid and methacrylic acid, a reaction product of 2-hydroxyethyl acrylate and methacrylic acid, and a reaction product of acrylic acid and methacrylic acid of ethylene glycol diglycidyl ether.

The content of (b) the hydrophilic monomer in the photosensitive resin layer is preferably 1.0% by mass or more and 50% by mass or less, and more preferably 1.0% by mass or more and 30% by mass or less with respect to 100% by mass of the photosensitive resin layer. With such a content adopted, photosensitivity is imparted to resin compositions, and a hardness suitable for the flexographic printing plate can be obtained after the photocuring.

(c) The photoinitiator may be any photoinitiator as long as it can initiate polymerization of a polymerizable carbon-carbon unsaturated group by light. Among them, a photoinitiator having a function of generating radicals by self-decomposition or hydrogen abstraction due to light absorption is preferably used. Examples of the photoinitiator include benzoin alkyl ethers, benzophenones, anthraquinones, benzils, acetophenones, and diacetyls.

The content of (c) the photoinitiator in the photosensitive resin layer is preferably 0.1% by mass or more and 20% by mass or less, and more preferably 0.5% by mass or more and 10% by mass or less with respect to 100% by mass of a photosensitive resin composition in order to sufficiently proceed a photocuring reaction during exposure and prevent an unexposed portion from being excessively affected by scattered light from an exposed portion.

(d) The hydrophilic plasticizer is a compound that does not have photocurability, but has a function of softening (a) the hydrophilic polymer. (a) The hydrophilic polymer strengthens the printing relief through hydrogen bonding between hydrophilic functional groups thereof, and since it is difficult to obtain flexibility required by the flexographic plate, (d) the hydrophilic plasticizer having a hydrophilic functional group compatible with (a) the hydrophilic polymer enters between molecules of (a) the hydrophilic polymer, such that the intermolecular network can be divided and the printing relief can be softened. In addition, (d) the hydrophilic plasticizer will not lose a function of imparting the flexibility even after the photocuring because of having no photocurability. In order to obtain such hydrophilicity, the hydrophilic functional group of (d) the hydrophilic plasticizer is preferably at least one of a hydroxy group, an amino group, an amide group, a carboxy group, and a phosphate group, and more preferably a hydroxy group.

In addition, since both (b) the hydrophilic monomer and (d) the hydrophilic plasticizer have at least one of a hydroxy group, an amino group, an amide group, a carboxy group, and a phosphate group, it is possible to effectively suppress changes in mass or physical properties due to swelling or elution caused by components included in the UV ink such as the tripropylene glycol diacrylate as described later.

Examples of such (d) hydrophilic plasticizer include polyethylene glycol and derivatives thereof, polypropylene glycol and derivatives thereof, derivatives of glycerin, derivatives of trimethylolethane, derivatives of trimethylolpropane, and derivatives of pentaerythritol.

A weight-average molecular weight of (d) the hydrophilic plasticizer is preferably 200 or more and 4,000 or less. Setting the weight-average molecular weight to 200 or more, more preferably 300 or more, makes it possible to suppress the changes in physical properties through extraction with the UV ink and to prevent the printing relief from being bulky. Setting the weight-average molecular weight to 4,000 or less, more preferably 1,000 or less, makes it possible to obtain a flexible printing relief.

The content of (d) the hydrophilic plasticizer in the photosensitive resin layer is preferably 5% by mass or more and 60% by mass or less with respect to 100% by mass of the photosensitive resin layer. Setting the content to 5% by mass or more, more preferably 20% by mass or more, makes it possible to obtain a flexible relief suitable for flexographic printing. In addition, setting the content to 60% by mass or less, more preferably 45% by mass or less, makes it possible to obtain a relief having a strength suitable for flexographic printing.

In addition, it is preferable that a total mass of (a) the hydrophilic polymer, (b) the hydrophilic monomer, and (d) the hydrophilic plasticizer in the photosensitive resin layer is 50% by mass or more and 100% by mass or less with respect to a total mass of a polymer, a monomer, and a plasticizer in the photosensitive resin layer. Setting the content to 50% by mass or more, more preferably 80% by mass or more, makes it possible to suppress swelling of the relief due to the UV ink, and prevent dot gain in the long-run printing.

(e) The ink repellent is a compound having a molecular structure with a relatively high polarity and a molecular structure having an ink-repellent action, and can exert an ink- repellent effect as the molecular structure having the relatively high polarity is held inside the photosensitive resin layer and the molecular structure having the ink-repellent action is oriented on a surface side of the photosensitive layer. The molecular structure having the ink-repellent action in (e) the ink repellent is preferably at least one of a structure having fluorine atoms or a structure having silicon atoms. The structure having fluorine atoms is more preferably a fluoroalkyl structure, and the structure having silicon atoms is more preferably a dimethylsiloxane structure.

The content of (e) the ink repellent in the photosensitive resin layer is preferably 0.1% by mass or more and 5.0% by mass or less with respect to 100% by mass of the photosensitive resin layer. With the blending amount being 0.1% by mass or more, more preferably 0.3% by mass or more, and still more preferably 0.4% by mass or more, an antifouling effect can be obtained, and with the blending amount being 5.0% by mass or less, and more preferably 3.0% by mass or less, a good ink adhesion property can be obtained when the printing relief is formed after exposure and development.

In order to increase thermal stability of the photosensitive resin layer of the photosensitive flexographic printing original plate of the present invention, a polymerization inhibitor can be added. Examples of a preferable polymerization inhibitor include phenols, hydroquinones, catechols, and hydroxyamine derivatives.

The content of the polymerization inhibitor in the photosensitive resin layer is preferably 0.001% by mass or more and 5% by mass or less with respect to 100% by mass of the photosensitive resin layer.

In addition, another component such as a dye, a pigment, a surfactant, a defoaming agent, an ultraviolet absorber, or a flavoring agent may be added into the photosensitive resin layer as required.

The thickness of the photosensitive resin layer is preferably 0.3 mm or more and 5.0 mm or less, from a viewpoint of having a sufficient relief depth and improving printability. Setting the thickness of the photosensitive resin layer to 0.3 mm or more, more preferably 0.5 mm or more, makes it possible to effectively obtain the irregularities required for the flexographic printing. In addition, with the thickness being 5.0 mm or less, more preferably 3.0 mm or less, an active ray used for exposure sufficiently reaches the bottom of the photosensitive resin layer, and thus the printing relief can be effectively formed.

The photosensitive flexographic printing original plate of the present invention preferably has a cover film on the photosensitive resin layer from the viewpoint of surface protection and prevention of adhesion of foreign matters. The photosensitive resin layer may be in direct contact with the cover film or may have one layer or a plurality of layers between the photosensitive resin layer and the cover film. Examples of the layer between the photosensitive resin layer and the cover film include an anti-adhesion layer provided for preventing surface adhesion of the photosensitive resin layer.

As a material of the cover film, a plastic sheet such as polyester or polyethylene is preferably used.

The thickness of the cover film is preferably 10 um or more and 150 um or less from a viewpoint of handleability and cost.

In addition, the surface of the cover film may be roughened. Roughening the surface of the cover film improves adhesion to an original image film.

The photosensitive flexographic printing original plate of the present invention may further have a heat-sensitive mask layer on the photosensitive resin layer. The heat-sensitive mask layer is preferably a layer that shields ultraviolet light and absorbs infrared laser light in drawing, and partially or entirely sublimates or ablates instantaneously due to heat. In this way, a difference in optical density between a laser-irradiated portion and a non-irradiated portion is provided, allowing the heat-sensitive mask layer to function in the same manner as a conventional original image film.

A method of producing the photosensitive flexographic printing original plate of the present invention will be described. However, the photosensitive flexographic printing original plate of the present invention is not limited to that produced by the method described herein.

After (a) the hydrophilic polymer is heated and dissolved in a water/alcohol mixed solvent, (b) the hydrophilic monomer, (c) the photoinitiator, (d) the hydrophilic plasticizer, and (e) the ink repellent, and other additives if necessary, are added, stirred and sufficiently mixed to obtain a photosensitive resin composition solution. However, the components (b) to (e) or other additives may be added before (a) the hydrophilic polymer is dissolved.

The photosensitive resin composition solution obtained is cast on the substrate optionally provided with an adhesion layer and then is dried to form the photosensitive resin layer made from the photosensitive resin composition. Then, tightly adhering the cover film optionally coated with the anti-adhesion layer onto the photosensitive resin layer can provide the photosensitive flexographic printing original plate. In addition, a photosensitive flexographic printing original plate can also be obtained by preparing a photosensitive resin sheet from the photosensitive resin composition solution by dry film formation, and laminating the photosensitive sheet to sandwich the photosensitive sheet between the substrate and the cover film.

The photosensitive flexographic printing original plate of the present invention can be used as the flexographic printing plate of the present invention by forming the printing relief having irregularities in a form of printing image through sufficient exposure as well as development and drying processes. As a plate-making method, conventionally known methods may be used.

In a case where the photosensitive flexographic printing original plate has no heat-sensitive mask layer (hereinafter referred to as an "analog plate") but has the cover film, the cover film is peeled off, a negative or positive original image film is tightly adhered onto the photosensitive resin layer, and then the photosensitive resin layer is photocured through ultraviolet irradiation.

In addition, in a case where the photosensitive flexographic printing original plate has the heat-sensitive mask layer (hereinafter referred to as a "CTP plate"), after the cover film is peeled off, and an image corresponding to the original image film is drawn by using a laser drawing machine, the photosensitive resin layer is photocured through the ultraviolet irradiation.

The ultraviolet irradiation is usually carried out by using, for example, a high-pressure mercury lamp, an ultrahigh-pressure mercury lamp, a metal halide lamp, a xenon lamp, a carbon arc lamp, and a chemical lamp, which can emit light having a wavelength of 300 nm or more and 400 nm or less. In particular, in a case where reproducibility of independent dots is required, it is also possible to perform short-time exposure (back exposure) from a support side before peeling off the cover film.

Next, the exposed photosensitive flexographic printing original plate is immersed in a developer to form the printing relief on the substrate by a brush-type development device that removes uncured portions by rubbing with a brush. In addition, a spray-type development device may also be used except the brush-type development device. A liquid temperature during development is preferably 15°C or more and 40°C or less.

The printing relief is dried at 50°C or more and 70°C or less for about 10 minutes after formation, and is optionally treated with the active ray in air or vacuum, whereby the photosensitive resin plate can be obtained.

In the flexographic printing plate of the present invention, it is important that the contact angle of the convex portion of the printing relief with respect to the tripropylene glycol diacrylate is 40° or more and 70° or less. Similarly, for the photosensitive flexographic printing original plate of the present invention, it is important that the contact angle of the photosensitive resin layer after the photocuring (that is, the convex portion of the printing relief of the flexographic printing plate) with respect to the tripropylene glycol diacrylate is 40° or more and 70° or less, when the photosensitive flexographic printing original plate is exposed and developed to reproduce 99 or more of 175 lpi, 3% halftone dots among 100 dots.

Here, "exposed to reproduce 99 or more of 175 lpi, 3% halftone dots among 100 dots" means a standard for performing sufficient exposure. Note that the "175 lpi" is the number of lines forming halftone dots arranged per inch (2.54 cm). Hereinafter, such condition is also referred to as a "standard exposure condition." As described above, since the flexographic printing plate of the present invention is suitably obtained by applying sufficient exposure to the photosensitive flexographic printing original plate of the present invention and passing through the development and drying processes, applying the standard exposure condition to the photosensitive flexographic printing original plate of the present invention results in that characteristics after exposure and development under the same condition can be considered as same as characteristics of the flexographic printing plate of the present invention.

The tripropylene glycol diacrylate is a typical monomer component included in the UV ink. Setting the contact angle with respect to the tripropylene glycol diacrylate to 40° or more, preferably 43° or more, makes it possible to prevent the ink entanglement and the dot gain due to entry of the ink into the concave portions. In addition, setting the contact angle to 70° or less, preferably 67° or less, and more preferably 55° or less, makes it possible to obtain good ink adhesion.

In addition, for the flexographic printing plate of the present invention, it is important that the mass change rate the convex portion of the printing relief after immersion in the tripropylene glycol diacrylate at 50°C for 24 hours is -4.0% or more and 4.0% or less. Similarly, for the photosensitive flexographic printing original plate of the present invention, it is important that the mass change rate of the photosensitive resin layer after photocuring (that is, the convex portion of the printing relief of the flexographic printing plate) after immersion in the tripropylene glycol acrylate at 50°C for 24 hours is -4.0% or more and 4.0% or less, when the photosensitive flexographic printing original plate is exposed and developed under the standard exposure condition. Setting the mass change rate of the printing relief after immersion at 50°C for 24 hours with respect to the tripropylene glycol diacrylate at the convex portion of the printing relief to 4.0% or less, preferably 1.0% or less, makes it possible to prevent the dot gain due to the swelling of the printing relief also in the ink, which is significant in the long-run printing. In addition, setting the mass change rate to -4.0% or more, preferably -3.0% or more, makes it possible to prevent the printing relief being bulky, and to continuously obtain a high-quality printed matter with a stable halftone density. The mass change due to ink immersion is preferably as close as 0.0%.

In the flexographic printing plate of the present invention, a tensile elastic modulus E_{A} measured is preferably 1.0 MPa or more and 20.0 MPa or less in a state where a solid image portion of 30 mm × 30 mm of the printing relief is stored for 24 hours in an environment of 30°C and a relative humidity of 20%. Similarly, when the photosensitive flexographic printing original plate of the present invention is exposed and developed to reproduce 99 or more of 175 lpi, 3% halftone dots among 100 dots to form the printing relief, the tensile elastic modulus E_{A} measured is preferably 1.0 MPa or more and 20.0 MPa or less with the solid image portion of 30 mm × 30 mm of the printing relief being stored for 24 hours in an environment of 30°C and a relative humidity of 20%.

Setting the E_{A} to 0.5 MPa or more, more preferably 1.0 MPa or more, makes it possible to obtain a strength for withstanding the printing pressure in the flexographic printing. In addition, setting the E_{A} to 20.0 MPa or less, and more preferably 10.0 MPa or less, makes it possible to obtain a good adhesion property even under printing pressure of kiss touch.

In the flexographic printing plate of the present invention, a difference between the E_{A} and a tensile elastic modulus E_{B} is measured after immersing the solid image portion of 30 mm × 30 mm of the printing relief in the tripropylene glycol diacrylate at 50°C for 24 hours, ΔE_{B} (= E_{B} - E_{A}) is preferably -1.0 MPa or more and 1.0 MPa or less. Similarly, when the photosensitive flexographic printing original plate of the present invention is exposed and developed to reproduce 99 or more of 175 lpi, 3% halftone dots among 100 dots to form the printing relief, the difference between the E_{A} and the tensile elastic modulus E_{B} measured after immersing the solid image portion of 30 mm × 30 mm of the printing relief in the tripropylene glycol diacrylate at 50°C for 24 hours, ΔE_{B} (= E_{B} - E_{A}) is preferably -1.0 MPa or more and 1.0 MPa or less.

Setting the ΔE_{B} to 1.0 MPa or less, more preferably 0.8 MPa or less, makes it possible to prevent a decrease in the adhesion property and to stably obtain a constant printing density even in the long-run printing. In addition, setting the ΔE_{B} to -1.0 MPa or more, more preferably -0.8 MPa or more, makes it possible to suppress a change in shape of the relief and to prevent the dot gain.

In the flexographic printing plate of the present invention, a difference between the E_{A} and a tensile elastic modulus E_{C} measured in a state where the solid image portion of 30 mm × 30 mm of the printing relief is stored for 2 hours in an environment of 40°C and a relative humidity of 80%, ΔE_{C} (= E_{C} - E_{A}) is preferably -1.0 MPa or more and 1.0 MPa or less. Similarly, when the photosensitive flexographic printing original plate of the present invention is exposed and developed under the standard exposure condition to form the printing relief, the difference between the E_{A} and the tensile elastic modulus E_{C} measured with the solid image portion of 30 mm × 30 mm of the printing relief being stored for 2 hours in the environment of 40°C and the relative humidity of 80%, ΔE_{C} (= E_{C} - E_{A}) is preferably -1.0 MPa or more and 1.0 MPa or less.

With ΔE_{C} set to 1.0 MPa or less, more preferably 0.8 MPa or less, the photosensitive flexographic printing original plate is hardly affected by a humidity of the printing environment, and even though the same type of flexographic printing plate is used in summer and winter when the humidity is greatly different, a constant printing density can be stably obtained without being affected by seasonal variations. In addition, setting ΔE_{C} to -1.0 MPa or more, preferably -0.8 MPa or more, makes it possible to suppress the change in shape of the relief and to prevent the dot gain even during long printing in a high-temperature and high-humidity environment.

In addition, with the flexographic printing plate of the present invention, a pattern image formed on the printing relief preferably has a resolution of 175 lpi or more. Setting the resolution to 175 lpi or more makes it possible to clearly print a photographic image. In addition, as the resolution increases, the flexographic printing plate is more likely to be affected by the ink entanglement and the dot gain, and particularly at a resolution of 175 lpi or more, an effect of suppressing the ink entanglement and the dot gain, which is a characteristic of the present invention, is significantly shown in a clear printed image.

The flexographic printing plate of the present invention can be suitably used for the flexographic printing using the UV ink. Examples of the flexographic printing UV ink include PHA (manufactured by T&K TOKA Corporation), "FLASH DRY" (registered trademark, manufactured by Toyo Ink Co., Ltd.) and "UVAFLEX" (registered trademark) Y77 (manufactured by Zeller + Gmelin), which are commercially available. Examples of the composition of such flexographic printing UV inks include a pigment, a resin such as acrylic oligomer, an acrylate monomer, and a photoinitiator. Using the flexographic printing plate of the present invention in printing prevents plate surface staining caused by wet-spreading of ink between halftone dots, and makes it possible to continuously obtain a high-quality printed matter without dot bridging. Further, even in long-run printing, it is possible to continuously obtain a high-quality printed matter without dot gain and with a stable halftone density.

The flexographic printing plate of the present invention can be suitably used for a seal label printing with the UV ink. In the seal label printing, reproduction of a high-definition pattern such as a photographic image may be required to improve appeal of a product to which a seal label is to be attached. However, the present invention can be suitably used for the application since the effect of suppressing the ink entanglement and the dot gain is particularly remarkably exerted in a high-resolution pattern of 175 lpi or more.

The photosensitive resin layer of the present invention is particularly suitable for using in the flexographic printing, but it also can be used for letterpress printing, dry-off printing, lithographic printing, intaglio printing, stencil printing, or a photoresist.

### EXAMPLES

Hereafter, the present invention will be described in detail with examples.

### [Evaluation methods and printing methods for evaluation]

Evaluations for each example and each comparative example were conducted by the following methods.

### (1) Ink contact angle

The degree of simplicity of wet spreading of the ink on a plate surface was evaluated by using a contact angle to the ink. Tripropylene glycol diacrylate of 1 µL was deposited on a solid portion of the plate surface at room temperature, and a contact angle after the deposition for 50 seconds was measured with a contact angle meter "DMe-201" (manufactured by Kyowa Interface Science Co., Ltd.). An average value for nine points was taken as a contact angle with respect to the tripropylene glycol diacrylate.

### (2) Mass change rate

A section obtained by cutting out the solid portion of the plate surface of 3 cm × 3 cm and a portion of about 0.8 mm from the surface in a depth direction was used as an evaluation sample, and a mass M₀ before immersion was measured with a precision balance. The evaluation sample was immersed in the tripropylene glycol diacrylate at a temperature of 50°C for 24 hours. Then, the sample was taken out from the tripropylene glycol diacrylate, the tripropylene glycol diacrylate was wiped off with a gauze from the sample surface, and a mass M₁ after immersion was immediately measured with the precision balance. The mass change rate due to ink immersion was calculated by (M₁ - M₀)/M₀, and an average value for nine samples was calculated.

### (3) Tensile elastic modulus

From the flexographic printing plate having the solid image portion of 30 mm × 30 mm or more in size in the printing relief, the solid image portion was cut into a size of 30 mm × 30 mm, and then scraped with a file from the substrate side, so that the substrate, the adhesion layer, and a part of the photosensitive resin layer were removed to prepare an evaluation sample having a thickness of 500 um to 600 µm.

This evaluation sample was stored and treated under the following conditions (A) to (C).

Condition (A): The evaluation sample was stored for 24 hours in an environment of 30°C and a relative humidity of 20%.

Condition (B): After immersion in the tripropylene glycol diacrylate at 50°C for 24 hours, the ink on the surface was wiped off with the gauze and removed.

Condition (C): The evaluation sample was stored for 2 hours in an environment of 40°C and a relative humidity of 80%.

Each of the evaluation samples stored and treated under the above conditions (A) to (C) was punched into a dumbbell shape of a reduced scale test piece A28 described in JIS K7139 to obtain test pieces (A) to (C) for evaluating a tensile elastic modulus.

The tensile elastic modulus was measured by a method in accordance with JIS K7161-1: 2014. Specifically, a stress-strain curve of the above test piece described above was measured at a distance between chucks of 10 mm and a tensile speed of 100 mm/min by using a tensile tester (a Tensilon universal tester RTM-100 manufactured by ORIENTEC CO., LTD.), and a slope of the stress-strain curve between two points at a strain ranging from 0.5% to 5.0% was defined as the tensile elastic modulus. The tensile elastic moduli of the test pieces (A) to (C) were defined as tensile elastic moduli E_{A}, E_{B}, and E_{C}, respectively.

Note that as for the tensile tester, an alternative product may be used as long as it conforms to the measurement in accordance with the above standard.

### (4) Printing method for evaluation

The printing plate was brought into close contact with a plate cylinder of a flexographic printing machine (MPS) equipped with a 1000 lpi anilox roll by using a cushion tape having a thickness of 0.38 um ("tesa softprint" (registered trademark) 52017 manufactured by TESA). Printing was performed on art paper at a speed of 70 m/min by using flexo ink ("UV Flexo Red PHA-LO3" manufactured by T&K TOKA CO., LTD.). The printing pressure was gradually applied, and the solid portion was fixed under a condition of being pressed by 60 um from the printing pressure at which a blur of the solid portion was eliminated.

### (5) Printing density

For the solid image portion of the flexographic printing plate, which has a width of 30 mm × 30 mm or more, a printing density was evaluated in order to evaluate the ink adhesion property. The printing density of the printed matter during printing of 100 m and during printing of 10,000 m from start of the printing was measured by using a spectrocolorimeter/densitometer ("SpectroEye" manufactured by X-Rite Inc.).

In addition, assuming a printing environment under a high humidity, a flexographic printing plate stored for 2 hours under an environment of 40°C and a relative humidity of 80% was also used to measure the printing density of the printed matter during printing of 100 m after the start of the printing.

### (6) Ink deposition area ratio

From the viewpoint that the dot bridging was caused by the ink that wet-spread on the plate surface, as for an evaluation by using an actual printing machine, the ink deposition area ratio on the plate surface was evaluated as an alternative index of the ink entanglement. For 175 lpi, 5% halftone dots and 30% halftone dots, presence or absence of the ink entanglement on the printed matter was confirmed, and after printing of 10,000 m, the surface of the flexographic printing plate was observed with a 50x loupe, and the ratio of an area where the ink was deposited to the total area of the concave portions between the plate and the halftone dots was evaluated as the ink deposition area ratio. It can be evaluated that the ink entanglement is less likely to occur as the ink deposition area ratio decreases.

### (7) Change rate of halftone dot diameter

Printed matters during printing of 100 m and during printing of 10,000 m from the start of printing were collected, and the dot gain was evaluated with the change rate of the halftone dot diameter. The 175 lpi, 30% halftone dot portion of the printed matter was enlarged with a microscope, the halftone dot diameter was measured, and the change rate from 105 um as a halftone dot diameter on data in the CTP was calculated. It can be evaluated that as a difference between the change rate of the halftone dot diameter during printing of 100 m and the change rate of the halftone dot diameter during printing of 10,000 m decreases, the dot gain in a long run decreases.

### [(a) Hydrophilic polymer 1]

Partially saponified polyvinyl alcohol having a saponification degree of 70 mol% to 74 mol% ("JR-05" manufactured by JAPAN VAM & POVAL CO., LTD.) was swollen in acetone, 1.0 mol% of succinic anhydride was added and stirred at 60°C for 6 hours, and a carboxy group was added to a molecular chain. The polymer was washed with the acetone to remove unreacted succinic anhydride and dried. After measurement, an acid value was 10.0 mg KOH/g. A carboxy group-containing polymer obtained by this operation was used as the hydrophilic polymer 1.

### [(a) Hydrophilic polymer 2]

Partially saponified polyvinyl alcohol having a saponification degree of 63 mol% to 67 mol% ("JMR-20M" manufactured by JAPAN VAM & POVAL CO., LTD.) was swollen in the acetone, 1.0 mol% of the succinic anhydride was added and stirred at 60°C for 6 hours, and a carboxy group is added to the molecular chain. The polymer was washed with the acetone to remove unreacted succinic anhydride and dried. The acid value was measured to be 10.2 mg KOH/g. A carboxy group-containing polymer obtained by this operation was used as the hydrophilic polymer 2.

### [(a) Hydrophilic polymer 3]

A copolymer (manufactured by Kyoeisha Chemical Co., Ltd.) having an amino group and a hydroxy group in a side chain and having a mass ratio of (dimethylaminoethyl methacrylate)/(2-hydroxyethyl methacrylate) of 2/1 was used as (a) the hydrophilic polymer 3.

### [(a) Hydrophilic polymer 4]

A pressure-resistant reaction vessel equipped with a stirrer and a temperature regulation jacket was initially charged with 125 parts by mass of water and 2 parts by mass of an ammonium salt of (α-sulfo(1-nonylphenoxy)methyl -2-(2-propenyloxy)ethoxy-poly(oxy -1,2-ethanediyl) ("Adekaria Soup" manufactured by ADEKA CORPORATION) as a reactive emulsifier, and an internal temperature of the pressure-resistant reaction vessel was raised to 80°C.

Next, an oily mixed solution of a monomer mixture composed of 10 parts by mass of styrene, 60 parts by mass of butadiene, 23 parts by mass of butyl acrylate, 5 parts by mass of methacrylic acid, and 2 parts by mass of acrylic acid, and 2 parts by mass of t-dodecyl mercaptan was added over 5 hours at a constant flow rate. Next, an aqueous solution composed of 28 parts by mass of water, 1.2 parts by mass of sodium peroxodisulfate, 0.2 parts by mass of sodium hydroxide, and 2 parts by mass of an ammonium salt of (α-sulfo(1-nonylphenoxy)methyl-2-(2-propenyloxy)ethoxy-poly(oxy-1,2-ethanediyl) was added at a constant flow rate over 6 hours.

Next, the polymerization reaction was completed while the temperature was maintained at 80°C for 1 hour, and then the mixture was cooled. After the pH of the produced copolymer latex was adjusted to 7 with sodium hydroxide, the unreacted monomers were removed by a steam stripping method, the mixture was filtered with a 200 mesh wire net, and was adjusted so that a solid content concentration of the filtrate finally was 40% by mass to obtain an aqueous dispersion of the hydrophilic polymer 4.

### [Example 1]

### (Preparation of substrate laminated film 1)

A mixture of 260 parts by weight of a toluene solution of a saturated polyester resin ("VYLON" (registered trademark) 31SS manufactured by TOYOBO CO., LTD.) and 2 parts by weight of benzoin ethyl ether ("PS-8A" manufactured by Wako Pure Chemical Corporation) was heated at 70°C for 2 hours and then cooled to 30°C, and 7 parts by weight of ethylene glycol diglycidyl ether dimethacrylate was added and mixed for 2 hours. Further, 25 parts by mass of an ethyl acetate solution of a polyvalent isocyanate resin ("Coronate" (registered trademark) 3015E manufactured by TOSOH CORPORATION) and 14 parts by mass of an industrial adhesive ("EC-1368" manufactured by Sumitomo 3M Limited) were added and mixed to obtain a coating liquid for an easily adhesive layer 1.

Fifty parts by mass of polyvinyl alcohol ("GOHSENOL" (registered trademark) KH-17 manufactured by The Nippon Synthetic Chemical Industry Co., Ltd.) having a saponification degree of 78.5 mol% to 81.5 mol% was mixed in a mixed solvent of 200 parts by mass of an alcohol mixture ("Solmix" (registered trademark) H-11 manufactured by Nippon Alcohol Co., Ltd.) and 200 parts by mass of water at 70°C for 2 hours, then 1.5 parts by mass of glycidyl methacrylate ("Blemmer" (registered trademark) G manufactured by NOF CORPORATION) was added and mixed for 1 hour, and 3 parts by mass of the copolymer (manufactured by Kyoeisha Chemical Co., Ltd.) having a mass ratio of (dimethylaminoethyl methacrylate)/(2-hydroxyethyl methacrylate) of 2/1, 5 parts by mass of benzylmethylketal ("IRGACURE" (registered trademark) 651 manufactured by Ciba Geigy), 21 parts by mass of a 2 acrylic acid adduct of propylene glycol diglycidyl ether ("Epoxy Ester 70PA" manufactured by Kyoeisha Chemical Co., Ltd.) and 20 parts by mass of ethylene glycol diglycidyl ether dimethacrylate were added and mixed for 90 minutes, and after being cooled to 50°C, 0.1 parts by mass of "Megafac" (registered trademark) F-556 (manufactured by DIC Corporation) was added and mixed for 30 minutes to obtain a coating liquid for easily adhesive layer 2.

The coating liquid for the easily adhesive layer 1 was applied onto a polyester (PET) film ("LUMIRROR" (registered trademark) T60 manufactured by Toray Industries, Inc.) having a thickness of 188 um with a bar coater so that the film thickness after drying was 30 µm, and heated in an oven at 180°C for 3 minutes to remove the solvent. A coating liquid for the easily adhesive layer 2 was applied thereon with a bar coater to have a dried film thickness of 20 µm, and heated in the oven at 130°C for 3 minutes to remove the solvent. In this way, a substrate laminated film 1 composed of the easily adhesive layer 2/the easily adhesive layer 1/the PET substrate was obtained.

### (Preparation of laminated film 1 for heat-sensitive mask layer)

As a film for the cover film, a polyester (PET) film ("LUMIRROR" S10 manufactured by Toray Industries, Inc.) having unroughened surfaces and a thickness of 100 um was used.

Eleven parts by mass of polyvinyl alcohol having a saponification degree of 91 mol% to 94 mol% ("GOHSENOL" (registered trademark) AL-05 manufactured by The Nippon Synthetic Chemical Industry Co., Ltd.) was dissolved in a mixed solvent of 55 parts by mass of water, 15 parts by mass of methanol, and 20 parts by mass of n-propanol to obtain a coating liquid for a peeling auxiliary layer.

Twenty-three parts by mass of carbon black (MA-100 manufactured by Mitsubishi Chemical Group Corporation), 1 part by mass of an alcohol insoluble acrylic resin ("Dianal" (registered trademark) BR-95 manufactured by Mitsubishi Rayon Co., Ltd.), 6 parts by mass of tributyl acetylcitrate ("ATBC" manufactured by J-PLUS Company, Limited) as a plasticizer, and 30 parts by mass of diethylene glycol monoethyl ether monoacetate were mixed in advance. Next, this mixture was kneaded and dispersed by using a three-roll mill to obtain a carbon black dispersion.

Twenty parts by mass of an epoxy resin ("Araldite" 6071 manufactured by Asahi Ciba Co., Ltd.), 27 parts by mass of a melamine resin ("U-VAN" (registered trademark) 62 manufactured by Mitsui Chemicals, Inc.), 0.7 parts by mass of a phosphoric acid monomer ("Light ester" P-1M manufactured by Kyoeisha Chemical Co., Ltd.), and 140 parts by mass of methyl isobutyl ketone were added to the carbon black dispersion, and stirred for 30 minutes. Then, methyl isobutyl ketone was further added so that the solid content concentration was 33% by mass, to obtain a coating liquid for the heat-sensitive mask layer 1.

Ten parts by mass of polyvinyl alcohol having a saponification degree of 78 mol% to 82mol% ("GOHSENOL" (registered trademark) KL-05 manufactured by The Nippon Synthetic Chemical Industry Co., Ltd.) was dissolved in 40 parts by mass of water, 20 parts by mass of methanol, and 30 parts by mass of n-propanol to obtain a coating liquid for the adhesion layer.

The coating liquid for the above peeling auxiliary layer was applied onto the film for the above cover film with the bar coater so that the film thickness after drying was 0.25 um, and dried at 100°C for 25 seconds. Further, the coating liquid for the above heat-sensitive mask layer 1 was applied onto the film with the bar coater so that the film thickness after drying was 2.0 µm, and dried at 140°C for 30 seconds. Further, the coating liquid for the above adhesion layer was applied onto the film with the bar coater so that the film thickness after drying was 1.0 µm, and dried at 180°C for 30 seconds to obtain the laminated film 1 for the heat-sensitive mask layer having a laminated configuration of the adhesion layer/the heat-sensitive mask layer 1/the peeling auxiliary layer/the cover film.

The optical density of the laminated film 1 for the heat-sensitive mask layer was 3.6 after measurement by zero-point correction when the transmitted light through the orthochromatic filter was used as incident light, the film for the above cover film was used as a blank.

### (Making of photosensitive flexographic printing original plate 1)

Forty parts by mass of (a) the hydrophilic polymer 1, 30 parts by mass of trimethylolpropane tri(polyethylene glycol)ether (with a weight-average molecular weight of 400, TMP-60 manufactured by Nippon Nyukazai Co., Ltd.) as (d) the hydrophilic plasticizer, 40 parts by mass of an alcohol mixture ("Solmix" (registered trademark) H-11 manufactured by Nippon Alcohol Co., Ltd.) as a solvent, and 60 parts by mass of distilled water were added into a three-necked flask equipped with a stirring spatula and a cooling tube, and then the mixture was heated at 77°C for 2 hours while being stirred to dissolve components (a) and (d) .

After this dissolved substance was cooled to 70°C, 5 parts by mass of glycidyl methacrylate was added to the dissolved substance, reacted for 1 hour, and added to (a) the hydrophilic polymer 1. At this time, a glycidyl group of glycidyl methacrylate is ring-opened by addition reaction with the carboxyl group of the hydrophilic polymer 1, and a hydroxy group is produced.

Next, 10 parts by mass of polyethylene glycol monomethacrylate (hydroxy group monofunctional group, "Blemmer" (registered trademark) AE400 manufactured by NOF CORPORATION) as (b) the hydrophilic monomer, 10 parts by mass of a 1 : 2 adduct of glycidyl acrylate of tripropylene glycol (Hydroxy group bifunctional, "Epoxy ester" (registered trademark) 200PA manufactured by NOF CORPORATION), 1.3 parts by mass of benzyl dimethyl ketal as (c) the photoinitiator, 0.6 parts by mass of a fluorine-containing quaternary ammonium salt compound ("FTERGENT 320" manufactured by NEOS COMPANY LIMITED) as (e) the ink repellent and 0.05 parts by mass of 2-(2'-hydroxy-3'-t-butyl -5'-methylphenyl)-5 chlorobenzotriazole as an ultraviolet absorber were added and stirred for 60 minutes to obtain a composition solution for a photosensitive resin layer 1.

The composition solution for the photosensitive resin layer 1 was adjusted so that the plate thickness (the substrate laminated film 1 + the photosensitive resin layer) after drying was 1.14 mm, cast on the substrate laminated film 1, and dried at 60°C for 2.5 hours. A mixed solvent in which a mass ratio of water/ethanol was 50/50 was applied onto the obtained photosensitive resin layer, and the laminated film 1 for the heat-sensitive mask layer was press-bonded to obtain the photosensitive flexographic printing original plate 1 having a laminated configuration of the cover film/the peeling auxiliary layer/the heat-sensitive mask layer 1/the adhesion layer/the photosensitive resin layer 1/the easily adhesive layer 2/the easily adhesive layer 1/the PET substrate.

### (Making of flexographic printing plate 1)

The photosensitive flexographic printing original plate 1 was cut into 10 cm × 10 cm, and back-exposed from the PET substrate side with a high luminance chemical lamp (TL-K40W/10R manufactured by Philips) so that an integrated light amount was about 700 mJ/cm². Next, the cover film was peeled off, and mounted on an outer drum-type platesetter ("CDI SPARK" 2530 manufactured by ESKO GRAPHICS CO., LTD.) equipped with a fiber laser having a region emitting infrared rays so that the PET substrate side was in contact with a drum, and a test pattern (175 lpi, 1% to 50% halftone dots, thin lines each having a width of 30 µm, independent points each having a diameter of 120 µm, punched lines each having a width of 300 um, and a solid portion of 40 mm × 40 mm) was drawn with a laser having an output of 2.4 J/cm² to form an image mask from the heat-sensitive mask layer. Then, under the atmosphere, main exposure was performed from an image mask side with the high-luminance chemical lamp TL-K 40W/10R similarly to the back exposure so that the integrated light amount was about 12,000 mJ/cm². Then, the photosensitive flexographic original printing plate was developed in tap water having a temperature adjusted to 25°C with a batch-type exposure development machine ("Inglese" W43 manufactured by Inglese, s. r. l.) for 80 seconds, and drying in the oven at 60°C for 10 minutes. Next, a post exposure was performed with the high-luminance chemical lamp TL-K 40W/10R so that the integrated light amount was about 12,000 mJ/cm² to obtain a flexographic printing plate 1.

When the 175 lpi, 3% halftone dots were confirmed with a loupe in the flexographic printing plate 1, it was confirmed that 100 out of 100 halftone dots can be reproduced. The ink contact angle of the flexographic printing plate 1 was shown as a high value of 49°. In addition, the mass change rate was -1.9%, indicating a slight change.

As for the tensile elastic modulus, E_{A} was 3.9 MPa, E_{B} was 3.1 MPa, E_{C} was 3.2 MPa, ΔE_{B} was -0.8 MPa, and ΔE_{C} was -0.7 MPa.

The printing density was 1.72 during printing of 100 m and was 1.70 during printing of 10,000 m, indicating that the printing density was stable even in the long run.

The ink deposition area ratio was 0% (no ink deposition) for each of the 175 lpi, 5% halftone dots and the 175 lpi, 30% halftone dots, and no ink entanglement was observed on the printed matter.

The change rate of the halftone dot diameter of the printed matter was -4.1% during printing of 100 m and -4.0% during printing of 10,000 m, indicating that almost no change was observed in printing length.

In addition, in a case of using the flexographic printing plate stored for 2 hours in a high humidity environment, the printing density of the printed matter during printing of 100 m was 1.73, indicating that the printing density was stable even in the high humidity environment.

### [Example 2]

A composition solution for a photosensitive resin layer 2 was obtained in the same manner as the composition solution for the photosensitive resin layer 1 of Example 1, except that 20 parts by mass of (a) the hydrophilic polymer 1 and 20 parts by mass of (a) the hydrophilic polymer 2 were used instead of 40 parts by mass of (a) the hydrophilic polymer 1 in the photosensitive resin composition.

The photosensitive flexographic printing original plate 2 having a laminated configuration of the cover film/the peeling auxiliary layer/the heat-sensitive mask layer 1/the adhesion layer/the photosensitive resin layer 2/the easily adhesive layer 2/the easily adhesive layer 1/the PET substrate, was made in the same manner as in Example 1, except that the composition solution for the photosensitive resin layer 2 was used instead of the composition solution for the photosensitive resin layer 1.

### (Making of flexographic printing plate 2)

The flexographic printing plate 2 was obtained in the same manner as in Example 1 except for using the photosensitive flexographic printing original plate 2.

When the 175 lpi, 3% halftone dots were confirmed with the loupe in the flexographic printing plate 2, it was confirmed that 100 out of 100 halftone dots can be reproduced. The ink contact angle of the flexographic printing plate 2 was shown as a high value of 49°. In addition, the mass change rate was -1.7%, indicating a slight change.

As for the tensile elastic modulus, E_{A} was 3.2 MPa, E_{B} was 2.7 MPa, E_{C} was 2.9 MPa, ΔE_{B} was -0.5 MPa, and ΔE_{C} was -0.3 MPa.

The printing density was 1.74 during printing of 100 m and was 1.73 during printing of 10,000, indicating that the printing density was stable even in the long run.

The ink deposition area ratio was 0% (no ink deposition) for each of the 175 lpi, 5% halftone dots and the 175 lpi, 30% halftone dots, and no ink entanglement was observed on the printed matter.

The change rate of the halftone dot diameter of the printed matter was -2.2% at both the time point of printing of 100 m and the time point of printing of 10,000 m, indicating no change by printing length.

In addition, in a case of using the flexographic printing plate stored for 2 hours in a high humidity environment, the printing density of the printed matter during printing of 100 m was 1.73, indicating that the printing density was stable even in the high humidity environment.

### [Example 3]

A composition solution for a photosensitive resin layer 3 was obtained in the same manner as the composition solution for the photosensitive resin layer 1 of Example 1, except that 35 parts by mass of (a) the hydrophilic polymer 1 and 5 parts by mass of (a) the hydrophilic polymer 3 were used instead of 40 parts by mass of (a) the hydrophilic polymer 1 in the photosensitive resin composition.

The photosensitive flexographic printing original plate 3 having a laminated configuration of the cover film/the peeling auxiliary layer/the heat-sensitive mask layer 1/the adhesion layer/the photosensitive resin layer 3/the easily adhesive layer 2/the easily adhesive layer 1/the PET substrate, was made in the same manner as in Example 1, except that the composition solution for the photosensitive resin layer 3 was used instead of the composition solution for the photosensitive resin layer 1.

### (Making of flexographic printing plate 3)

The flexographic printing plate 3 was obtained in the same manner as in Example 1 except for using the photosensitive flexographic printing original plate 3.

When the 175 lpi, 3% halftone dots were confirmed with the loupe in the flexographic printing plate 3, it was confirmed that 100 out of 100 halftone dots can be reproduced. The ink contact angle of the flexographic printing plate 3 was shown as a high value of 46°. In addition, the mass change rate was +0.5%, indicating a slight change.

As for the tensile elastic modulus, E_{A} was 3.5 MPa, E_{B} was 3.0 MPa, E_{C} was 3.1 MPa, ΔE_{B} was -0.5 MPa, and ΔE_{C} was -0.4 MPa.

The printing density was 1.72 during printing of 100 m and was 1.71 during printing of 10,000, indicating that the printing density was stable even in the long run.

The ink deposition area ratio was 0% (no ink deposition) for each of the 175 lpi, 5% halftone dots and the 175 lpi, 30% halftone dots, and no ink entanglement was observed on the printed matter.

The change rate of the halftone dot diameter of the printed matter was +0.5%% during printing of 100 m and +0.7% during printing of 10,000 m, indicating that almost no change by printing length was observed.

In addition, in the case of using the flexographic printing plate stored for 2 hours in a high humidity environment, the printing density of the printed matter during printing of 100 m was 1.71, indicating that the printing density was stable even in the high humidity environment.

### [Comparative Example 1]

A composition solution for a photosensitive resin layer 4 was obtained in the same manner as the composition solution for the photosensitive resin layer 1 of Example 1, except that trimethylolpropane (with a molecular weight of 134) was used as (d) the hydrophilic plasticizer in the photosensitive resin composition instead of trimethylolpropane tri(polyethylene glycol)ether.

The photosensitive flexographic printing original plate 4 having a laminated configuration of the cover film/the peeling auxiliary layer/the heat-sensitive mask layer 1/the adhesion layer/the photosensitive resin layer 4/the easily adhesive layer 2/the easily adhesive layer 1/the PET substrate, was made in the same manner as in Example 1, except that the composition solution for the photosensitive resin layer 4 was used instead of the composition solution for the photosensitive resin layer 1.

### (Making of flexographic printing plate 4)

The flexographic printing plate 4 was obtained in the same manner as in Example 1 except for using the photosensitive flexographic printing original plate 4.

When the 175 lpi, 3% halftone dots were confirmed with the loupe in the flexographic printing plate 4, it was confirmed that 100 out of 100 halftone dots could be reproduced. The ink contact angle of the flexographic printing plate 4 was shown as a high value of 49°. On the other hand, the mass change rate was -5.3%, indicating that the amount of the tripropylene glycol diacrylate extracted from the flexographic printing plate 4 was large.

As for the tensile elastic modulus, E_{A} was 3.4 MPa, E_{B} was 4.5 MPa, E_{C} was 2.6 MPa, ΔE_{B} was +1.1 MPa, and ΔE_{C} was -0.8 MPa.

The printing density was 1.70 during printing of 100 m, and 1.65 during printing of 10,000, indicating that the printing density slightly decreased in the long run, and blur occurred in a part of the printing region.

The ink deposition area ratio was 0% (no ink deposition) for each of the 175 lpi, 5% halftone dots and the 175 lpi, 30% halftone dots, and no ink entanglement was observed on the printed matter.

The change rate of the halftone dot diameter of the printed matter was -3.9% during printing of 100 m and -4.4% during printing of 10,000 m, indicating a slight change in printing length. In addition, during printing of 10,000 m, blur occurred in the solid part, and the printing density was reduced.

In the case of using the flexographic printing plate stored for 2 hours in a high humidity environment, the printing density of the printed matter during printing of 100 m was 1.71, indicating that the printing density in the high humidity environment was stable.

### [Comparative Example 2]

A composition solution for a photosensitive resin layer 5 was obtained similarly to the composition solution for the photosensitive resin layer 1 of Example 1, except that as one component of (b) the hydrophilic monomer in the photosensitive resin composition, the 1 : 2 adduct of glycidyl acrylate of tripropylene glycol was changed to polyethylene glycol dimethacrylate ("Slemmer" AD400 manufactured by NOF CORPORATION) without a hydroxy group.

The photosensitive flexographic printing original plate 5 having a laminated configuration of the cover film/the peeling auxiliary layer/the heat-sensitive mask layer/the adhesion layer/the photosensitive resin layer 5/the easily adhesive layer 2/the easily adhesive layer 1/the PET substrate, was made in the same manner as in Example 1, except that the composition solution for the photosensitive resin layer 5 was used instead of the composition solution for the photosensitive resin layer 1.

### (Making of flexographic printing plate 5)

The flexographic printing plate 5 was obtained in the same manner as in Example 1 except for using the photosensitive flexographic printing original plate 5.

When the 175 lpi, 3% halftone dots were confirmed with the loupe in the flexographic printing plate 5, it was confirmed that 100 out of 100 halftone dots can be reproduced. The ink contact angle of the flexographic printing plate 5 was shown as a high value of 48°. On the other hand, the mass change rate was -5.1%, indicating that the amount of the tripropylene glycol diacrylate extracted from the flexographic printing plate 5 was large.

As for the tensile elastic modulus, E_{A} was 4.0 MPa, E_{B} was 5.5 MPa, E_{C} was 3.6 MPa, ΔE_{B} was +1.5 MPa, and ΔE_{C} was -0.4 MPa.

The printing density was 1.70 during printing of 100 m, and 1.55 during printing of 10,000, indicating that the printing density decreased in the long run, and blur occurred in a part of the printing region.

The ink deposition area ratio was 0% (no ink deposition) for each of the 175 lpi, 5% halftone dots and the 175 lpi, 30% halftone dots, and no ink entanglement was observed on the printed matter. The change rate of the halftone dot diameter of the printed matter was -4.1% during printing of 100 m and -4.4% during printing of 10,000 m, indicating that the change by printing length was slight, but blur occurred in the solid portion, and the printing density decreased during printing of 10,000 m.

The change rate of the halftone dot diameter of the printed matter was -4.1% during printing of 100 m and -4.4% during printing of 10,000 m, indicating a slight change by printing length.

In the case of using the flexographic printing plate stored for 2 hours in a high humidity environment, the printing density of the printed matter during printing of 100 m was 1.71, indicating that the printing density in the high humidity environment was stable.

### [Comparative Example 3]

### (Preparation of laminated film 2 for substrate)

A PET film coated with an elastomer-containing adhesive and having a thickness of 100 um was used as the laminate film 2 for the substrate.

### (Preparation of laminated film 2 for heat-sensitive mask layer)

As a film for the cover film, a polyester (PET) film ("LUMIRROR" S10 manufactured by Toray Industries, Inc.) having unroughened surfaces and a thickness of 100 um was used.

Ten parts by mass of a 20% by mass aqueous solution of an ethylene-acrylic acid copolymer (SG-2000 manufactured by Namariichi Co., Ltd.) that is an anionic polymer having a carboxylic acid group as an anionic polar functional group, 5 parts by mass of a 20% by mass aqueous solution of carbon black ("BONJET" CW-2 manufactured by Orient Chemical Industries Co., Ltd.), 0.05 parts by mass of a release agent (KF-351 manufactured by Shin-Etsu Chemical Co., Ltd.), 30 parts by mass of water, and 15 parts by mass of ethanol were mixed to obtain a coating liquid for the heat-sensitive mask layer 2.

The coating liquid for the above heat-sensitive mask layer 2 was applied onto the film for the above cover film with the bar coater so that the film thickness after drying was 3.0 µm, and dried at 90°C for 2 minutes to obtain the laminated film 2 for the heat-sensitive mask layer having a laminated configuration of the heat-sensitive mask layer 2/the cover film.

### (Making of photosensitive flexographic printing original plate 6)

Five parts by mass of 3-methacryloxypropyl trimethoxysilane (KBM305 manufactured by Shin-Etsu Chemical Co., Ltd.) and 10 parts by mass of liquid polybutadiene (LBR352 manufactured by Kuraray Co., Ltd.) as the plasticizer were mixed with respect to 100 parts by mass of the aqueous dispersion of the hydrophilic polymer 4, and dried under a reduced pressure at 80°C to obtain a dried mixture of the hydrophilic polymer 4 and the liquid polybutadiene. One hundred and ten parts by mass of this mixture and 75 parts by mass of a styrene-butadiene-styrene copolymer (D-KX405 manufactured by Kraton Corporation) as a hydrophobic polymer were mixed at 140°C by using a pressure kneader, then a mixture of 40 parts by mass of the liquid polybutadiene (LBR-352 manufactured by Kuraray Co., Ltd.), 10 parts by mass of 1,9-nonanediol diacrylate and 10 parts by mass of 1,6-hexanediol dimethacrylate as non-hydrophilic monomers, 5 parts by mass of 2,2-dimethoxyphenylacetophenone as (c) the photoinitiator, 2 parts by mass of surfactant (NT-12 manufactured by DKS Co., Ltd.), and 5 parts by mass of 2,6-di-t-butyl-p-cresol as a stabilizer was gradually added over 15 minutes, and kneaded for further 20 minutes after being completely added to obtain a composition for a photosensitive resin layer 6.

The composition for the above photosensitive resin layer 6 was sandwiched between a PET film having a thickness of 100 um and coated with an elastomer-containing adhesive for the substrate and a PET film having a thickness of 100 um and coated with a polyvinyl alcohol (PVA) layer having a thickness of 5 µm, and molded into a plate shape having a thickness of 1.14 mm by using a pressing machine heated to 120°C. Next, the PET film on the side coated with the PVA layer was peeled off to obtain a laminate having a laminated configuration of the photosensitive resin layer 6/the elastomer-containing adhesive layer/the PET substrate.

The laminated film 2 for the heat-sensitive mask layer was laminated on the obtained laminate to make the photosensitive flexographic printing original plate 6 having a laminated configuration of the cover film/the heat-sensitive mask layer 2/the photosensitive resin layer 6/the elastomer-containing adhesive layer/the PET substrate.

### (Making of flexographic printing plate 6)

The photosensitive flexographic printing original plate 6 was exposed by using an ultraviolet exposer (JE-A2-SS manufactured by Nihon Denshi Seiki Co., Ltd.) from the PET substrate side so that the pattern height after curing was about 0.6 mm. Next, the cover film was peeled off, and mounted on an outer drum-type platesetter ("CDI SPARK" 2530 manufactured by ESKO GRAPHICS CO., LTD.) equipped with a fiber laser having a region emitting infrared rays so that the PET substrate side was in contact with a drum, and a test pattern (175 lpi, 1% to 50% halftone dots, thin lines each having a width of 30 um, independent points each having a diameter of 120 um, punched lines each having a width of 300 um, and a solid portion of 40 mm × 40 mm) was drawn with a laser having an output of 2.4 J/cm² to form an image mask from the heat-sensitive mask layer. Then, the photosensitive flexographic printing original plate was exposed for 10 minutes with the above ultraviolet exposer from the heat-sensitive mask layer side under the atmosphere. After the exposure, an aqueous solution (an aqueous developer) of 1% Nissan soap was prepared, and the photosensitive flexographic printing original plate was washed (developed) at 40°C for 5 minutes by using a washing machine (JOW-A3-P manufactured by Nihon Denshi Seiki Co., Ltd.) to remove the unexposed portion, thereby obtaining the flexographic printing plate 6.

When the 175 lpi, 3% halftone dots were confirmed with the loupe in the flexographic printing plate 6, it was confirmed that 99 out of 100 halftone dots can be reproduced. The ink contact angle of the flexographic printing plate 6 was shown as a high value of 47°. On the other hand, the mass change rate was +6.2%, indicating a significant swelling as compared with Example 1.

As for the tensile elastic modulus, E_{A} was 3.0 MPa, E_{B} was 1.1 MPa, E_{C} was 2.8 MPa, ΔE_{B} was -1.9 MPa, and ΔE_{C} was -0.2 MPa.

The printing density was 1.73 during printing of 100 m and 1.90 during printing of 10,000, indicating that the printing density increased in the long run. This is presumed to be an influence of swelling and softening of the flexographic printing plate in the ink due to the long-run printing.

The ink deposition area ratio was 0% (no ink deposition) for 175 lpi, 30% halftone dots, but the ink deposition area ratio was 60% for 175 lpi, 5% halftone dots, indicating that a large amount of the ink was deposited on the plate surface, and the ink entanglement was observed on the printed matter.

The change rate of the halftone dot diameter of the printed matter was + 3.0% during printing of 100 m and + 15.3% during printing of 10,000 m, indicating that the dot gain was increased due to the long-run printing, and as the printing density increased, the influence of swelling of the flexographic printing plate in the long-run printing was large.

In the case of using the flexographic printing plate stored for 2 hours in a high humidity environment, the printing density of the printed matter during printing of 100 m was 1.72, indicating that the printing density in the high humidity environment was stable.

### [Comparative Example 4]

### (Making of photosensitive flexographic printing original plate 7)

A composition solution for a photosensitive resin layer 7 was obtained in the same manner as the composition solution for the photosensitive resin layer 1 of Example 1, except that the fluorine-containing quaternary ammonium salt compound as (e) the ink repellent in the photosensitive resin composition was not added.

The photosensitive flexographic printing original plate 7 having a laminated configuration of the cover film/the peeling auxiliary layer/the heat-sensitive mask layer 1/the adhesion layer/the photosensitive resin layer 7/the easily adhesive layer 2/the easily adhesive layer 1/the PET substrate was made in the same manner as in Example 1, except that the composition solution for the photosensitive resin layer 7 was used instead of the composition solution for the photosensitive resin layer 1.

### (Making of flexographic printing plate 7)

The flexographic printing plate 7 was obtained in the same manner as in Example 1 except for using the photosensitive flexographic printing original plate 7.

When the 175 lpi, 3% halftone dots were confirmed with the loupe in the flexographic printing plate 7, it was confirmed that 100 out of 100 halftone dots can be reproduced. The ink contact angle of the flexographic printing plate 1 was shown as a low value of 25°. In addition, the mass change rate was -1.9%, indicating a slight change.

As for the tensile elastic modulus, E_{A} was 4.0 MPa, E_{B} was 3.2 MPa, E_{C} was 3.3 MPa, ΔE_{B} was -0.8 MPa, and ΔE_{C} was -0.7 MPa.

The printing density was 1.72 during printing of 100 m and was 1.71 during printing of 10,000 m, indicating that the printing density was stable even in the long run.

The ink deposition area ratio was 0% (no ink deposition) for 175 lpi, 30% halftone dots, but the ink deposition area ratio was 60% for 175 lpi, 5% halftone dots, indicating that a large amount of the ink was deposited on the plate surface, and the ink entanglement was observed on the printed matter.

The change rate of the halftone dot diameter of the printed matter was -4.1% during printing of 100 m and -4.0% during printing of 10,000 m, indicating that almost no change was observed in printing length.

In addition, in the case of using the flexographic printing plate stored for 2 hours in a high humidity environment, the printing density of the printed matter during printing of 100 m was 1.73, indicating that the printing density in the high humidity environment was stable.

### [Example 4]

### (Making of photosensitive flexographic printing original plate 8)

A composition solution for a photosensitive resin layer 8 was obtained in the same manner as the composition solution for the photosensitive resin layer 1 of Example 1, except that the addition amount of the fluorine-containing quaternary ammonium salt compound as (e) the ink repellent in the photosensitive resin composition was changed from 0.6 parts by mass to 0.3 parts by mass.

The photosensitive flexographic printing original plate 8 having a laminated configuration of the cover film/the peeling auxiliary layer/the heat-sensitive mask layer 1/the adhesion layer/the photosensitive resin layer 8/the easy-to-adhesion layer 2/the easy adhesion layer 1/the PET substrate was made in the same manner as in Example 1 except that the composition solution for the photosensitive resin layer 8 was used instead of the composition solution for the photosensitive resin layer 1.

### (Making of flexographic printing plate 8)

The flexographic printing plate 8 was obtained in the same manner as in Example 1 except for using the photosensitive flexographic printing original plate 8.

When the 175 lpi, 3% halftone dots were confirmed with the loupe in the flexographic printing plate 8, it was confirmed that 100 out of 100 halftone dots can be reproduced. The ink contact angle of the flexographic printing plate 1 was shown as a relatively high value of 42°. In addition, the mass change rate was -1.9%, indicating a slight change.

As for the tensile elastic modulus, E_{A} was 3.9 MPa, E_{B} was 3.1 MPa, E_{C} was 3.2 MPa, ΔE_{B} was -0.8 MPa, and ΔE_{C} was -0.7 MPa.

The printing density was 1.72 during printing of 100 m and was 1.70 during printing of 10,000 m, indicating that the printing density was stable even in the long run.

The ink deposition area ratio was 0% (no ink deposition) for 175 lpi, 30% halftone dots, but the ink deposition area ratio was 3% for 175 lpi, 5% halftone dots, indicating that the ink was slightly deposited on the plate surface. However, the ink entanglement was not observed on the printed matter.

The change rate of the halftone dot diameter of the printed matter was -4.1% during printing of 100 m and -4.0% during printing of 10,000 m, indicating that almost no change was observed in printing length.

In addition, in the case of using the flexographic printing plate stored for 2 hours in a high humidity environment, the printing density of the printed matter during printing of 100 m was 1.73, indicating that the printing density in the high humidity environment was also stable.

## Claims

1. A photosensitive flexographic printing original plate comprising at least a substrate and a photosensitive resin layer, wherein the photosensitive resin layer contains at least (a) a hydrophilic polymer, (b) a hydrophilic monomer, (c) a photoinitiator, (d) a hydrophilic plasticizer, and (e) an ink repellent, and when the photosensitive flexographic printing original plate is exposed and developed to reproduce 99 or more of 175 lpi, 3% halftone dots among 100 dots, a contact angle of the photosensitive resin layer after photocuring with respect to tripropylene glycol diacrylate is 40° or more and 70° or less, and a mass change rate of the photosensitive resin layer after the photocuring after immersion in the tripropylene glycol acrylate at 50°C for 24 hours is -4.0% or more and 4.0% or less.

2. The photosensitive flexographic printing original plate according to claim 1, wherein (d) the hydrophilic plasticizer has a weight-average molecular weight of 200 or more and 4,000 or less.

3. The photosensitive flexographic printing original plate according to claim 1 or 2, wherein (e) the ink repellent includes at least one or more compounds selected from a compound including fluorine atoms and a compound having silicon atoms.

4. The photosensitive flexographic printing original plate according to any one of claims 1 to 3, wherein (a) the hydrophilic polymer has at least one of a hydroxy group, an amino group, an amide group, a carboxy group, and a phosphate group.

5. The photosensitive flexographic printing original plate according to any one of claims 1 to 4, wherein (b) the hydrophilic monomer has at least one of a hydroxy group, an amino group, an amide group, a carboxy group, and a phosphate group.

6. The photosensitive flexographic printing original plate according to any one of claims 1 to 4, wherein (d) the hydrophilic plasticizer has at least one of a hydroxy group, an amino group, an amide group, a carboxy group, and a phosphate group.

7. The photosensitive flexographic printing original plate according to any one of claims 1 to 4, wherein (b) the hydrophilic monomer and (d) the hydrophilic plasticizer both have at least one of a hydroxy group, an amino group, an amide group, a carboxy group, and a phosphate group.

8. The photosensitive flexographic printing original plate according to any one of claims 1 to 7, wherein a total mass of (a) the hydrophilic polymer, (b) the hydrophilic monomer, and (d) the hydrophilic plasticizer in the photosensitive resin layer is 50% by mass or more and 100% by mass or less with respect to a total mass of a polymer, a monomer, and a plasticizer in the photosensitive resin layer.

9. The photosensitive flexographic printing original plate according to any one of claims 1 to 8, wherein when the photosensitive flexographic printing original plate is exposed and developed to reproduce 99 or more of 175 lpi, 3% halftone dots among 100 dots, a tensile elastic modulus E_{A} measured in a state where a solid image portion of 30 mm × 30 mm of a printing relief is stored for 24 hours under an environment of 30°C and a relative humidity of 20% is 0.5 MPa or more and 20.0 MPa or less, and a difference between the E_{A} and a tensile elastic modulus E_{B} measured after immersion of the solid image portion of 30 mm × 30 mm of the printing relief in the tripropylene glycol diacrylate at 50°C for 24 hours, ΔE_{B} (= E_{B} - E_{A}) is -1.0 MPa or more and 1.0 MPa or less.

10. A flexographic printing plate comprising a resin layer having at least a printing relief formed on a substrate, wherein a contact angle of a convex portion of the printing relief with respect to tripropylene glycol diacrylate is 40° or more and 70° or less, and a mass change rate of the convex portion of the printing relief after immersion in tripropylene glycol diacrylate at 50°C for 24 hours is -4.0% or more and 4.0% or less.

11. The flexographic printing plate according to claims 10, wherein a tensile elastic modulus E_{A} measured in a state where a solid image portion of 30 mm × 30 mm of the printing relief is stored for 24 hours under an environment of 30°C and a relative humidity of 20% is 0.5 MPa or more and 20.0 MPa or less, and a difference between the E_{A} and a tensile elastic modulus E_{B} measured after immersion of the solid image portion of 30 mm × 30 mm of the printing relief in the tripropylene glycol diacrylate at 50°C for 24 hours, ΔE_{B} (= E_{B} - E_{A}) is -1.0 MPa or more and 1.0 MPa or less.

12. The flexographic printing plate according to claim 11, wherein a difference between the E_{A} and a tensile elastic modulus E_{C} measured in a state where the solid image portion of 30 mm × 30 mm of the printing relief is stored for 2 hours under an environment of 40°C and a relative humidity of 80%, ΔE_{C} (= E_{C} - E_{A}) is -1.0 MPa or more and 1.0 MPa or less.

13. The flexographic printing plate according to any one of claims 10 to 12, wherein a pattern image formed on the printing relief has a resolution of 175 lpi or more.
